(19) Europäisches Patentamt
European Patent Office
Office européen des brevets

(11) **EP 4 651 187 A1**

(12) **EUROPEAN PATENT APPLICATION**
published in accordance with Art. 153(4) EPC

(43) Date of publication:
**19.11.2025 Bulletin 2025/47**

(21) Application number: **23916315.7**

(22) Date of filing: **28.12.2023**

(51) International Patent Classification (IPC):
**H01L 21/66** (2006.01)

(52) Cooperative Patent Classification (CPC):
**H01L 22/00**

(86) International application number:
**PCT/JP2023/047262**

(87) International publication number:
**WO 2024/150702 (18.07.2024 Gazette 2024/29)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **13.01.2023 JP 2023004069**

(71) Applicant: **Tokyo Electron Limited Tokyo 107-6325 (JP)**

(72) Inventor: **KASAI, Shigeru Nirasaki City, Yamanashi 407-8511 (JP)**

(74) Representative: **Diehl & Partner Patent- und Rechtsanwaltskanzlei mbB Erika-Mann-Straße 9 80636 München (DE)**

(54) **INSPECTION SYSTEM AND TEMPERATURE CONTROL METHOD**

(57) Provided are an inspection system and a temperature control method for inspecting a substrate while performing appropriate temperature control. The inspection system, which inspects a substrate while performing temperature control, includes a substrate holder that holds the substrate; a detector that supplies inspection power to an electrode of the substrate; a holder temperature adjustment mechanism that detects a temperature of the substrate holding unit, and adjusts the temperature of the substrate holder; a detector temperature adjustment mechanism that detects a temperature of the detector, and adjusts the temperature of the detector; and a controller. The controller adjusts the temperature control performed by the holder temperature adjustment mechanism and the detector temperature adjustment mechanism while the substrate is being inspected.

FIG. 2

**Description**

TECHNICAL FIELD

The present disclosure relates to an inspection system and a temperature control method.

BACKGROUND

Patent Document 1 discloses a power conversion apparatus capable of estimating a junction temperature of a power transistor with high precision by detecting a voltage between source and drain terminals during an on-period of the power transistor.

[Prior Art Document]

[Patent Document]Patent Document 1: Japanese Patent Laid-open Publication No. 2019-122107

SUMMARY

Some embodiments of the present disclosure provide an inspection system and a temperature control method, which are capable of inspecting a substrate while performing temperature control appropriately.

According to an embodiment, there is provided an inspection system that inspects a substrate while performing temperature control. The inspection system includes a substrate holder configured to hold the substrate, a detector configured to supply inspection power to an electrode of the substrate, a holder temperature adjustment mechanism configured to detect a temperature of the substrate holder and adjust the temperature of the substrate holder, a detector temperature adjustment mechanism configured to detect a temperature of the detector and adjust the temperature of the detector, and a controller, wherein the controller is configured to perform inspection of the substrate while adjusting temperature control performed by the holder temperature adjustment mechanism and the detector temperature adjustment mechanism.

According to the present disclosure, it is possible to provide an inspection system and a temperature control method, which are capable of inspecting a substrate while performing temperature control appropriately.

BRIEF DESCRIPTION OF DRAWINGS

FIG. 1 is an example of a perspective view of an inspection system.
FIG. 2 is an example of a configuration diagram of the inspection system.
FIG. 3 is an example of a plan view schematically illustrating a configuration of a substrate.
FIG. 4 is an example of an enlarged view of the inspection system and illustrates a vicinity of an electronic device in an enlarged scale.
FIG. 5 is an example of a diagram illustrating a heat flow model.
FIG. 6 is an example of a block diagram for explaining state estimation by an observer.
FIG. 7 is an example of a block diagram for explaining state feedback.

DETAILED DESCRIPTION

Hereinafter, various exemplary embodiments will be described in detail with reference to the drawings. In addition, the same reference numerals will be given to the same or corresponding parts in each drawing.

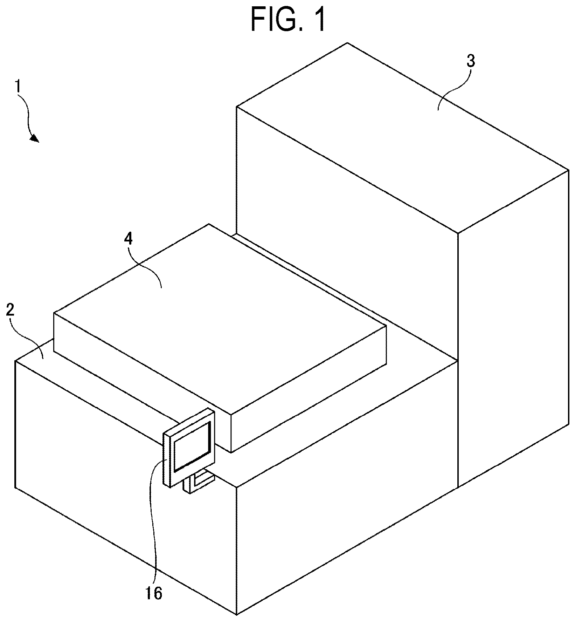

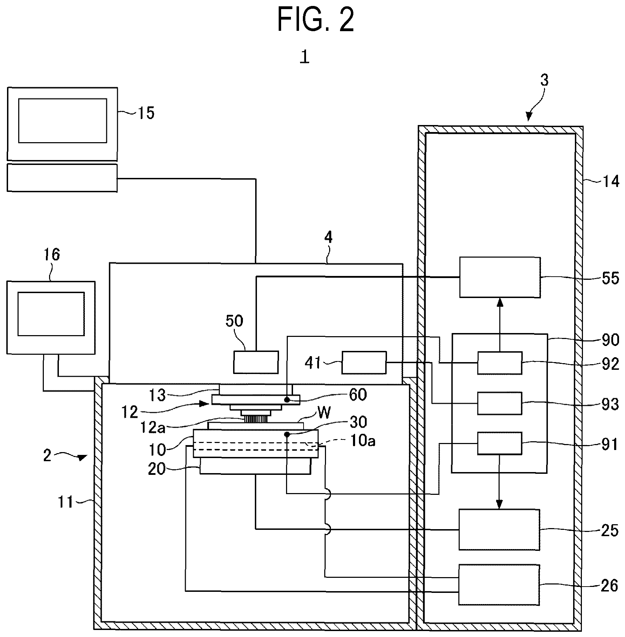

An inspection system 1, which is an example of an inspection system according to the present embodiment, will be described with reference to FIG. 1. FIG. 1 is an example of a perspective view of the inspection system 1. FIG. 2 is an example of a configuration diagram of the inspection system 1. In addition, FIG. 2 is a partial cross-sectional view and schematically illustrates components incorporated in the inspection system 1.

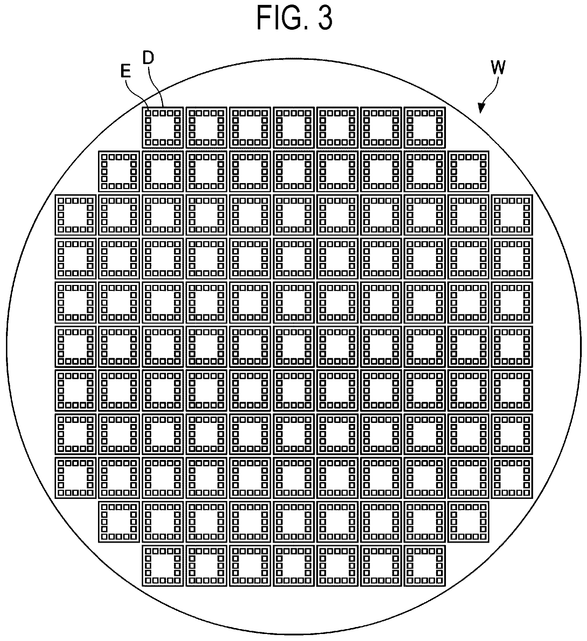

In a semiconductor manufacturing process, a plurality of electronic devices D (also referred to as dies; *see* FIG. 3 described later) each having a predetermined circuit pattern are formed on a substrate W such as a semiconductor wafer. The formed electronic devices D are subjected to an inspection, such as an electrical characteristics inspection or the like, and are sorted into acceptable and defective products. The inspection of the electronic devices D is performed using the inspection system 1, for example, before the substrate W is diced into the electronic devices D.

The inspection system 1 performs an electrical characteristics inspection of electronic devices D formed on the substrate W (*see* FIG. 3 described later) while performing temperature control. In other words, the inspection system 1 supplies inspection power to the electronic devices D while a temperature of the electronic devices D is set to be equal to or higher than a predetermined inspection temperature, and inspects electrical characteristics of the electronic devices D at that time.

The inspection system 1 includes an accommodation chamber 2, a loader 3, and a tester 4.

The accommodation chamber 2 includes a hollow housing 11. The accommodation chamber 2 includes a stage (also referred to as "chuck") 10, on which the substrate W is placed, inside the housing 11. The stage 10 includes an adsorption holder (not illustrated) that adsorbs and holds the substrate W without any deviation in a relative position of the substrate W to the stage 10. Further, the accommodation chamber 2 includes a movement mechanism (not illustrated) that is provided inside the housing 11 and moves the stage 10 in horizontal and vertical directions. By the movement mechanism, a relative position of the substrate W to a probe card 12 (to be described later) can be adjusted to bring a desired electrode E on a surface of the substrate W (*see* FIG. 3 described later) into contact with a probe 12a of the probe card 12.

The accommodation chamber 2 includes the probe card 12 inside the housing 11. The probe card 12 is disposed above the stage 10 to face the stage 10. The probe card 12 includes a plurality of needle-shaped probes 12a disposed correspondingly to electrode pads or solder bumps that correspond to the electrodes E of each electronic device D on the substrate W. The probe card 12 is connected to the tester 4 via an interface 13. During the electrical characteristics inspection, the probes 12a are brought into contact with the electrodes E of the electronic device D on the substrate W, respectively, to supply power from the tester 4 to the electronic device D via the interface 13, and deliver signals from the electronic device D to the tester 4 via the interface 13.

In the loader 3, a front opening unify pod (FOUP) as a transfer container accommodating the substrate W is disposed. Further, the loader 3 includes a transfer mechanism (not illustrated) that transfers the substrate W. The transfer mechanism takes out the substrate W accommodated in the FOUP and transfers the substrate W to the stage 10 in the accommodation chamber 2. Furthermore, the transfer mechanism receives the substrate W having been subjected to the electrical characteristics inspection of the electronic device D from the stage 10, and accommodates the substrate W in the FOUP.

The tester 4 includes a test board (not illustrated) that emulates a part of a circuit configuration of a motherboard on which the electronic device D is mounted. In addition, the test board of the tester 4 is connected to a tester computer 15 that determines whether the electronic device D is acceptable or defective based on the signals from the electronic device D. The tester 4 can emulate circuit configurations of various types of motherboards by replacing the test board. Further, the plurality of probes 12a of the probe card 12 are brought into contact with the plurality of electrodes E of the electronic device D, respectively. Furthermore, the tester 4 may include a plurality of detection means for detecting electrical characteristics of the electronic device D. Thus, the tester 4 may detect various electrical characteristics of the electronic device D.

The inspection system 1 further includes a user interface 16 that displays information for user and receives instructions from a user. The user interface 16 includes, for example, an input such as a touch panel or keyboard and a display such as a liquid crystal display.

As described above, the inspection system 1 includes the stage 10 as a substrate holder that holds the substrate W. Further, the inspection system 1 includes, as a detector that detects electrical characteristics of the electronic device D by supplying inspection power to the electrodes E of the electronic device D provided on the substrate W, the probe card 12 including the probes 12a, the interface 13, and the tester 4.

In addition, the loader 3 includes a temperature control unit 14. The temperature control unit 14 includes a power supply 25, a chiller 26, a power supply 55, and a controller 90.

The stage 10 is provided with a heater 20 that heats the stage 10. The power supply 25 supplies power to the heater 20 provided on the stage 10. Further, a coolant flow path 10a, through which a heat transfer medium (e.g., antifreeze) flows, is formed inside the stage 10. The chiller 26 circulates a temperature-adjusted heat transfer medium through the coolant flow path 10a. As described above, the inspection system 1 includes, as a holder temperature adjustment mechanism that adjusts a temperature of the substrate holder, the heater 20, the power supply 25, the coolant flow path 10a, and the chiller 26. In addition, a configuration of the holder temperature adjustment mechanism is not limited to those described above.

The holder temperature adjustment mechanism includes a temperature detector 30 that detects the temperature of the substrate holder. The temperature detector 30 is provided in the stage 10 to detect a temperature Tchuck of the stage 10. The temperature Tchuck of the stage 10 detected by the temperature detector 30 is input to the controller 90. Although a single temperature detector 30 is illustrated in the drawing, the temperature detector 30 is not limited thereto. With respect to the electronic device D that receives power and generates heat, a plurality of temperature detectors 30 may be provided in the stage 10. Further, when switching the electronic device D that receives power and generates heat, the temperature detector 30 that detects the temperature Tchuck may also be switched. Furthermore, the temperature Tchuck may be detected based on a model including the plurality of temperature detectors 30.

The tester 4 is provided with a temperature regulation mechanism 50 that regulates a temperature of the probe card 12. The temperature regulation mechanism 50 may include a heater (not illustrated) that heats the probe card 12, a cooling fan (not illustrated) that air-cools the probe card 12, and the like. The power supply 55 supplies power to the temperature regulation mechanism 50 provided in the tester 4. As described above, the inspection system 1 includes the temperature regulation mechanism 50 as a detector temperature adjustment mechanism that adjusts a temperature of the detector. A configuration of the detector temperature adjustment mechanism is not limited to those described above. The detector temperature adjustment mechanism may include a configuration in which the temperature of the detector is adjusted by liquid-cooling.

The detector temperature adjustment mechanism includes a temperature detector 60 that detects the temperature of the detector. The temperature detector 60 is provided in the probe card 12 to detect a temperature Tprob of the probe card 12. The temperature Tprob of the probe card 12 detected by the temperature detector 60 is input to the controller 90. The temperature detector 60 is illustrated as being provided in the probe card 12, but is not limited thereto. The temperature detector 60 may be any temperature detector capable of detecting a temperature representative of the temperature of the probes. For example, the temperature detector 60 may be a temperature detector that detects a temperature of the probes 12a. Although a single temperature detector 60 is illustrated in the drawing, the temperature detector 60 is not limited thereto. With respect to the electronic device D that receives power and generates heat, a plurality of temperature detectors 60 may be provided in the probe card 12. Furthermore, when switching the electronic device D that receives power and generates heat, the temperature detector 60 that detects the temperature Tprob may also be switched. Furthermore, the temperature Tprob may be detected based on a model including the plurality of temperature detectors 60.

The tester 4 includes a power detector 41 that detects inspection power (current and voltage) supplied from the tester 4 to the electronic device D via the interface 13 and the probe card 12. The inspection power detected by the power detector 41 is input to the controller 90.

The controller 90 includes a holder temperature controller 91, a detector temperature controller 92, and an analyzer 93. The controller 90 controls the holder temperature adjustment mechanism and the detector temperature adjustment mechanism so that a junction temperature Tj of the electronic device D (temperature of the substrate W) becomes the inspection temperature. Further, the controller 90 controls the holder temperature adjustment mechanism and the detector temperature adjustment mechanism so that a temperature difference between the substrate W and the probe card 12 falls within a predetermined threshold.

The holder temperature controller 91 controls the holder temperature adjustment mechanism so that the temperature Tchuck of the substrate holder detected by the temperature detector 30 becomes a target temperature. Although a single temperature detector 30 is illustrated in the drawing, the temperature detector 30 is not limited thereto. With respect to the electronic device D that receives power and generates heat, a plurality of temperature detectors 30 may be provided in the stage 10. Further, when switching the electronic device D that receives power and generates heat, the temperature detector 30 that detects the temperature Tchuck may also be switched. Furthermore, the temperature Tchuck may be detected based on a model including the plurality of temperature detectors 30. That is, the holder temperature controller 91 controls the temperature Tchuck of the stage 10 by controlling the power supply 25 to control an amount of heat generated by the heater 20. The holder temperature controller 91 may control the temperature Tchuck of the stage 10 by controlling the chiller 26 to control a temperature of the heat transfer medium supplied to the coolant flow path 10a by the chiller 26.

The detector temperature controller 92 controls the detector temperature adjustment mechanism so that the temperature Tprob detected by the temperature detector 60 becomes a target temperature. That is, the detector temperature controller 92 controls the temperature Tprob of the probe card 12 by controlling the power supply 55 to control the temperature regulation mechanism 50. Although a single temperature detector 60 is illustrated in the drawing, the temperature detector 60 is not limited thereto. With respect to the electronic device D that receives power and generates, a plurality of temperature detectors 60 may be provided in the probe card 12. Further, when switching the electronic device D that receives power and generates heat, the temperature detector 60 that detects the temperature Tprob may also be switched. Furthermore, the temperature Tprob may be detected based on a model including the plurality of temperature detectors 60.

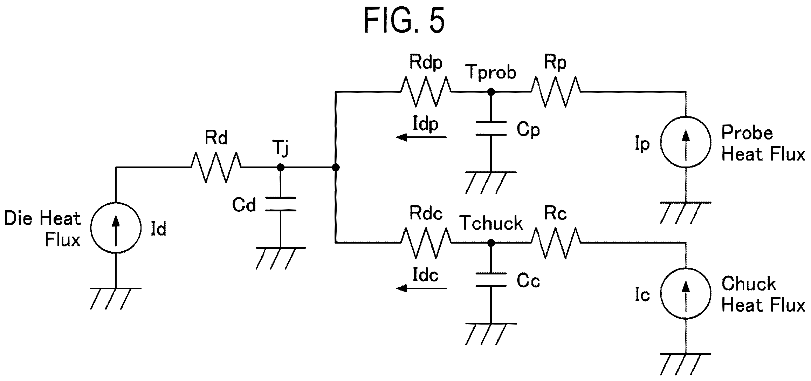

The analyzer 93 estimates the junction temperature Tj of the electronic device D (temperature of the substrate W) based on a heat flow model, which will be described later with reference to FIG. 5. Further, the controller 90 adjusts a chuck heat flux (see a heat flow Ic to be described later with reference to FIG. 5) so that the temperature Tchuck becomes the target temperature (target holder temperature), and adjusts a probe heat flux (see a heat flow Ip to be described later with reference to FIG. 5) so that the temperature Tprob becomes the target temperature (target detector temperature). The holder temperature controller 91 controls the holder temperature adjustment mechanism based on the target holder temperature calculated by the analyzer 93. Further, the detector temperature controller 92 controls the detector temperature adjustment mechanism based on the target detector temperature calculated by the analyzer 93. Here, there are multiple solutions for the target holder temperature and the target detector temperature, which are calculated by the analyzer 93. Further, actually, approximately 40% of heat escapes from the electronic device D to the probe card 12. An amount of heat absorbed from the electronic device D to the probe card 12 is in a trade-off relationship with a thermal expansion difference between the probe card 12 and the substrate W. The amount of heat absorbed from the electronic device D to the probe card 12 is calculated by an amount of heat absorbed in a range in which the probes 12a enters the bonding pads (electrodes E).

Next, the substrate W inspected by the above-described inspection system 1 will be described with reference to FIG. 3. FIG. 3 is a plan view schematically illustrating a configuration of the substrate W.

As illustrated in FIG. 3, the electronic devices D are formed on the surface of the substrate W at predetermined intervals from one another by performing etching and wiring on a substantially disk-shaped silicon substrate. The electrodes E are formed on each electronic device D, that is, on the surface of the substrate W, and the electrodes E are electrically connected to circuit elements in the electronic device D. By applying a voltage to the electrodes E, a current may flow through the circuit elements in each electronic device D.

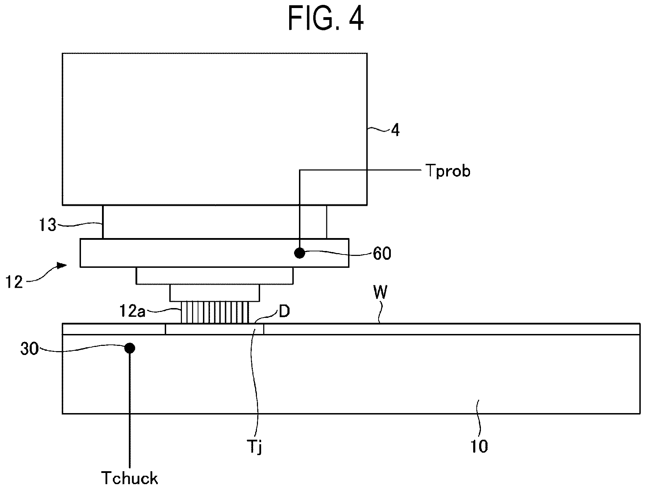

FIG. 4 is an example of an enlarged view of the inspection system 1 and illustrates a vicinity of the electronic device D in an enlarged scale.

During the inspection of electrical characteristics of the electronic device D, the substrate W is held by the stage 10. In other words, the electronic device D is thermally connected to the stage 10. Further, during the inspection of electrical characteristics of the electronic device D, the probes 12a are in contact with the electrodes E of the electronic device D. In other words, the electronic device D is thermally connected to the probe card 12 via the probes 12a. Further, the probe card 12 is in contact with the interface 13, and the interface 13 is in contact with the tester 4. In other words, the probe card 12 is thermally connected to the tester 4 via the interface 13, and the tester 4 is thermally connected to the electronic device D via the probe card 12.

The temperature Tchuck of the stage 10 is detected by the temperature detector 30. Further, the temperature Tprob of the probe card 12 is detected by the temperature detector 60.

Here, by causing a current to flow through a PN junction (e.g., a transistor) formed in the electronic device D, the junction temperature Tj of the electronic device D may be detected from a correlation between a generated electromotive force and a temperature. However, under conditions in which a clock signal is generated, for example, during the inspection of the electronic device D such as a logic IC, the junction temperature Tj may not be detected appropriately due to influence of noise and the like.

Further, when the electronic device D is inspected, a temperature difference is generated between the temperature Tchuck of the stage 10 and the junction temperature Tj of the electronic device D due to a thermal resistance between the stage 10 and the substrate W (electronic device D). Therefore, when the electronic device D is inspected while temperature control is performed to set the temperature Tchuck of the stage 10 to be the inspection temperature, it is concerned that the junction temperature Tj of the electronic device D becomes higher than the inspection temperature. In other words, it is concerned that the electronic device D is inspected at a temperature higher than the inspection temperature, which may result in deterioration in yield of the electronic device D.

Furthermore, when the electronic device D is inspected while a temperature-control is performed to set the temperature Tchuck of the stage 10 to be the inspection temperature, a heat flow from the electronic device D to the detector serves as disturbance.

Moreover, the substrate W is mainly made of silicon, for example, and the probe card 12 is mainly made of glass epoxy, for example. Thus, it is concerned that a thermal expansion difference is generated due to a temperature difference between the substrate W and the probe card 12, which may cause the probes 12a to deviate from the electrodes E.

Next, temperature control in the inspection system 1 according to the present embodiment will be described. FIG. 5 is an example of a diagram for explaining a heat flow model.

FIG. 5 illustrates a heat flow Id of the electronic device D, a thermal resistance Rd of the electronic device D, a heat capacity Cd of the electronic device D, and the junction temperature Tj of the electronic device D. Further, FIG. 5 illustrates the heat flow Ip of the probe card 12, a thermal resistance Rp of the probe card 12, a heat capacity Cp of the probe card 12, the temperature Tprob of the probe card 12 (probe card temperature), a heat flow Idp from the probe card 12 to the electronic device D, and a thermal resistance Rdp from the probe card 12 to the electronic device D. Furthermore, FIG. 5 illustrates the heat flow Ic of the stage 10, a thermal resistance Rc of the stage 10, a heat capacity Cc of the stage 10, the temperature Tchuck of the stage 10 (chuck temperature), a heat flow Idc from the stage 10 to the electronic device D, and a thermal resistance Rdc from the stage 10 to the electronic device D. FIG. 5 illustrates a single temperature detector 30 (see FIGS. 2 and 4) that detects the temperature Tchuck. However, performance may be further improved by providing and switching a plurality of temperature detectors 30, or by detecting the temperature Tchuck based on a model including a plurality of temperature detectors 30.

Here, the various thermal resistances and various heat capacities are predetermined values (values that can be obtained in advance) according to configurations of the substrate holder, the substrate W, the detector, and the like.

The heat flow Id of the electronic device D corresponds to a heat flow by the inspection power detected by the power detector 41. The heat flow Ic of the stage 10 corresponds to a heat flow in the holder temperature adjustment mechanism. The heat flow Ip of the probe card 12 corresponds to a heat flow in the detector temperature adjustment mechanism. In other words, the heat flows Id, Ic, and Ip are values that can be detected by the controller 90.

The temperature Tchuck of the stage 10 (chuck temperature) corresponds to a temperature detected by the temperature detector 30. The temperature Tprob of the probe card 12 (probe card temperature) corresponds to a temperature detected by the temperature detector 60. In other words, the temperatures Tchuck and Tprob are values that can be detected by the controller 90.

On the other hand, the junction temperature Tj of the electronic device D is a temperature that cannot be directly measured by the controller 90.

In the heat flow model illustrated in FIG. 5, a differential value of the junction temperature Tj (Tj dot), a differential value of the temperature Tprob of the probe card 12 (Tprob dot), and a differential value of the temperature Tchuck of the stage 10 (Tchuck dot) may be expressed by the following equations.

[Equations 1]

$$\dot{T}_j = \frac{\dot{Q}_d}{C_d} = \frac{1}{C_d}\left(i_{dp} + i_{dc} + i_d\right) = \frac{i_{dp}}{C_d} + \frac{i_{dc}}{C_d} + \frac{i_d}{C_d} = \frac{1}{C_d}(T_{chuck} - T_j) + \frac{1}{C_d}(T_{prob} - T_j) + \frac{i_d}{C_d}$$

$$\dot{T}_{chuck} = \frac{\dot{Q}_c}{C_c} = \frac{i_c}{C_c} - \frac{1}{C_c \cdot R_{dp}}(T_{chuck} - T_j)$$

$$\dot{T}_{prob} = \frac{\dot{Q}_p}{C_p} = \frac{i_p}{C_p} - \frac{1}{C_p \cdot R_{dc}}(T_{prob} - T_j)$$

Here, when $X_1$=Tj, $X_2$=Tchuck, $X_3$=Tprob, $U_1$=Id, $U_2$=Ic, and $U_3$=Ip, the following equations are obtained.

[Equations 2]

$$\begin{bmatrix} \dot{X}_1 \\ \dot{X}_2 \\ \dot{X}_3 \end{bmatrix} = \begin{bmatrix} -\dfrac{2}{C_d} & \dfrac{1}{C_d} & \dfrac{1}{C_d} \\ -\dfrac{1}{C_c \cdot R_{dp}} & \dfrac{1}{C_c \cdot R_{dp}} & 0 \\ -\dfrac{1}{C_p \cdot R_{dc}} & 0 & \dfrac{1}{C_p \cdot R_{dc}} \end{bmatrix} \begin{bmatrix} X_1 \\ X_2 \\ X_3 \end{bmatrix} + \begin{bmatrix} \dfrac{1}{C_d} & \dfrac{1}{C_c} & \dfrac{1}{C_p} \end{bmatrix} \begin{bmatrix} U_1 \\ U_2 \\ U_3 \end{bmatrix}$$

$$\begin{bmatrix} Y_1 \\ Y_2 \\ Y_3 \end{bmatrix} = \begin{bmatrix} 0 & 1 & 1 \end{bmatrix} \begin{bmatrix} X_1 \\ X_2 \\ X_3 \end{bmatrix}$$

That is, the above equations may be expressed as dx/dt=Ax(t)+Bu(t) and y(t)=Cx(t).

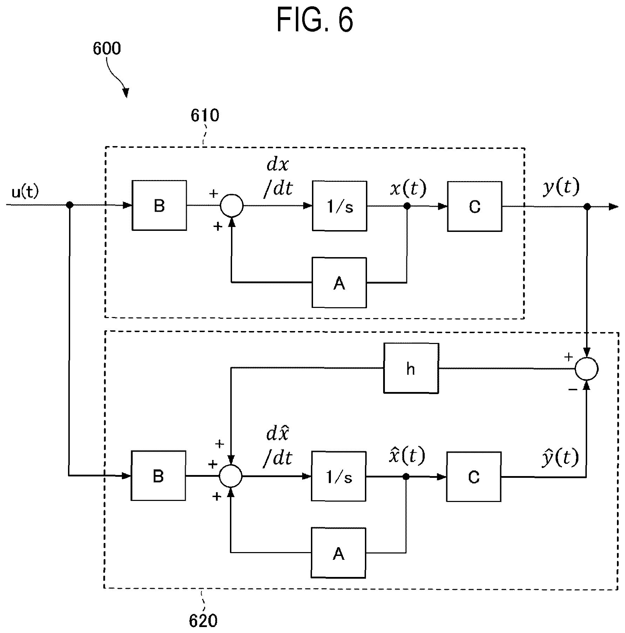

FIG. 6 is an example of a block diagram for explaining state estimation by an observer. Block diagram 600 includes a control target object 610 and an observer 620. The control target object 610 corresponds to the above-described equations. Here, x(t) is a value that cannot be measured. By using the observer 620, an estimated value of x(t) (in FIG. 6, a hat "^" is added to values estimated by the observer 620) can be calculated.

In other words, the analyzer 93 can estimate the junction temperature Tj of the electronic device D, which is not directly measurable, in the heat flow model illustrated in FIG. 5 by using the observer 620 illustrated in FIG. 6.

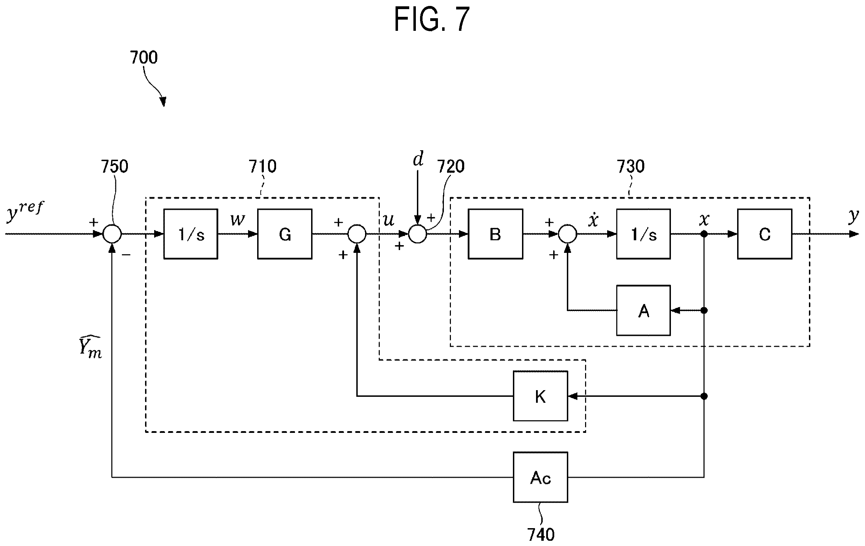

FIG. 7 is an example of a block diagram for explaining state feedback. Block diagram 700 includes an integral controller 710, an operator 720, a control target object 730, an operator 740, and an operator 750. In addition, although not illustrated, the control target object 730 illustrated in FIG. 7 includes an observer, similar to the block diagram 600 illustrated in FIG. 6. The estimated value of x(t) estimated by the observer is input to the integral controller 710 and the operator 740.

The integral controller 710 state-feedbacks the estimated value of x(t) estimated by the observer.

Here, the estimated value of $X_1$ estimated by the observer (Xi hat) is given as $Y_1$. That is, $Y_1$ is the junction temperature Tj estimated by the observer. A difference between the estimated value of $X_1$ ($X_1$ hat) estimated by the observer and $X_3$ is given as $Y_2$. That is, $Y_2$ is a difference between the junction temperature Tj estimated by the observer and the temperature Tprob, and is an estimated value of a temperature difference between the substrate W (electronic device D) and the probe card 12. Those described above may be expressed by the following equation.

[Equation 3]

$$\begin{bmatrix} \widehat{Y_{m1}} \\ \widehat{Y_{m2}} \\ \widehat{Y_{m3}} \end{bmatrix} = Ac \cdot \widehat{X} = \begin{bmatrix} 1 & 0 & 0 \\ 1 & 0 & -1 \\ 0 & 0 & 0 \end{bmatrix} \begin{bmatrix} \widehat{X_1} \\ \widehat{X_2} \\ \widehat{X_3} \end{bmatrix}$$

The operator 740 feeds back the estimated values of $Y_m$ ($Y_m$ hat) based on the above equation to the operator 750.

Thus, the junction temperature Tj and the difference between the junction temperature Tj and the temperature Tprob are fed back.

In addition, the integral controller 710 may be configured such that $Y_2$ is faster than $Y_1$.

As described above, the controller 90 performs inspection of the substrate W while adjusting the temperature control performed by the holder temperature adjustment mechanism and the detector temperature adjustment mechanism.

Specifically, the controller 90 can perform the inspection of the substrate W while adjusting the temperature (junction temperature Tj) of the substrate W, by acquiring and collectively analyzing the heat flow Id by the inspection power output when the inspection power is supplied, the heat flow Ic in the holder temperature adjustment mechanism, and the heat flow Ip in the detector temperature adjustment mechanism. Thus, since the electronic device D can be set to have a desired inspection temperature during the inspection of the electronic device D, it is possible to perform the inspection appropriately. Further, it is possible to prevent deterioration in the yield of the electronic device D.

In addition, the controller 90 can performs the inspection of the substrate W while adjusting the difference between the temperature (junction temperature Tj) of the substrate W and the temperature (temperature Tprob) of the detector, by acquiring and collectively analyzing the heat flow Id by the inspection power output when the inspection power is supplied, the heat flow Ic in the holder temperature adjustment mechanism, and the heat flow Ip in the detector temperature adjustment mechanism. Thus, the thermal expansion difference between the substrate W and the probe card 12 is suppressed, and the probes 12a is prevented from deviating from the electrodes E. Further, it is possible to minimize friction between the probes 12a and the electrodes E.

In addition, the analyzer 93 of the controller 90 can estimate the junction temperature Tj of the electronic device D, based on the heat flow Id by the inspection power, the heat flow Ic in the holder temperature adjustment mechanism, the heat flow Ip in the detector temperature adjustment mechanism, the temperature Tchuck of the substrate holder, and the temperature Tprob of the detector. Thus, it is possible to reduce costs for packaging the electronic device D, compared to a configuration in which an electrodes E only for detecting the junction temperature Tj of the electronic device is provided. Further, the number of probes 12a provided in the probe card 12 can be reduced.

The heat flow Id by the inspection power is obtained from, for example, the inspection power detected by the power detector 41. The heat flow Ic in the holder temperature adjustment mechanism is obtained from, for example, the input power of the power supply 25. The heat flow Ip in the detector temperature adjustment mechanism is obtained from, for example, the input power of the power supply 55.

The controller 90 controls the holder temperature adjustment mechanism and the detector temperature adjustment mechanism so that the junction temperature Tj becomes the inspection temperature. Thus, since the junction temperature Tj of the electronic device D can be set to be the inspection temperature during the inspection of the electronic device D, it is possible to perform the inspection appropriately. Further, it is possible to prevent deterioration in the yield of the electronic device D.

Further, the controller 90 controls the holder temperature adjustment mechanism and the detector temperature adjustment mechanism so that the temperature difference between the substrate W and the probe card 12 falls within a predetermined threshold. Thus, it is possible to suppress the thermal expansion difference, and to prevent the probes 12a from deviating from the electrodes E. Further, it is possible to minimize friction between the probes 12a and the electrodes E.

Furthermore, the analyzer 93 of the controller 90 calculates the target holder temperature and the target detector temperature, based on the heat flow Id by the inspection power, the heat flow Ic in the holder temperature adjustment mechanism, the heat flow Ip in the detector temperature adjustment mechanism, the temperature Tchuck of the substrate holder, and the temperature Tprob of the detector.

The holder temperature controller 91 controls the temperature of the substrate holder to be the target holder temperature. In other words, the holder temperature controller 91 controls the power supply 25 for the heater 20 and/or the chiller 26 so that the temperature Tchuck detected by the temperature detector 30 approaches the target holder temperature. Further, the detector temperature controller 92 controls the temperature of the detector to be the target detector temperature. In other words, the detector temperature controller 92 controls the power supply 55 for the temperature regulation mechanism 50 so that the temperature Tprob detected by the temperature detector 60 approaches the target detector temperature.

Here, the target holder temperature and the target detector temperature are set such that the estimated junction temperature Tj approaches the inspection temperature. Thus, since the junction temperature Tj of the electronic device D can be set to be the inspection temperature during the inspection of the electronic device D, it is possible to perform the inspection appropriately. Further, it is possible to prevent deterioration in the yield of the electronic device D.

In addition, the target holder temperature and the target detector temperature are set such that the difference between the estimated junction temperature Tj and the temperature Tprob of the probe card 12 is equal to or smaller than a threshold. Thus, it is possible to suppress the thermal expansion difference, and to prevent the probes 12a from deviating from the electrodes E. Further, it is possible to minimize friction between the probes 12a and the electrodes E.

Although the inspection system 1 has been described above, the present disclosure is not limited to the above-described embodiment, and various modifications and improvements can be made within the scope of the gist of the present disclosure described in the claims.

This application claims a priority based on Japanese Patent Application No. 2023-4069 filed on January 13, 2023, and the entire content of this Japanese patent application is incorporated herein by reference.

EXPLANATION OF REFERENCE NUMERALS

W: substrate, D: electronic device, E: electrode, 1: inspection system, 2: accommodation chamber, 3: loader, 4: tester, 10: stage, 10a: coolant flow path, 12: probe card, 12a: probe, 13: interface, 14: temperature control unit, 20: heater, 25: power supply, 26: chiller, 30: temperature detector, 41: power detector, 50: temperature regulation mechanism, 55: power supply, 90: controller, 91: holder temperature controller, 92: detector temperature controller, 93: analyzer, 60: temperature detector

**Claims**

1.  An inspection system that inspects a substrate while performing temperature control, comprising:

    a substrate holder configured to hold the substrate;
    a detector configured to supply inspection power to an electrode of the substrate;
    a holder temperature adjustment mechanism configured to detect a temperature of the substrate holder and adjust the temperature of the substrate holder;
    a detector temperature adjustment mechanism configured to detect a temperature of the detector and adjust the temperature of the detector; and
    a controller,
    wherein the controller is configured to perform inspection of the substrate while adjusting temperature control performed by the holder temperature adjustment mechanism and the detector temperature adjustment mechanism.

2.  The inspection system of Claim 1, wherein the controller performs the inspection of the substrate while adjusting a temperature of the substrate, by acquiring and collectively analyzing a heat flow by the inspection power, which is output when the inspection power is supplied, a heat flow in the holder temperature adjustment mechanism, and a heat flow in the detector temperature adjustment mechanism.

3.  The inspection system of Claim 1, wherein the controller performs the inspection of the substrate while adjusting a temperature difference between the substrate and the detector, by acquiring and collectively analyzing a heat flow by the inspection power, which is output when the inspection power is supplied, a heat flow in the holder temperature adjustment mechanism, and a heat flow in the detector temperature adjustment mechanism.

4.  The inspection system of Claim 1, wherein the controller estimates a temperature of the substrate, based on a heat flow by the inspection power, which is output when the inspection power is supplied, a heat flow in the holder temperature adjustment mechanism, a heat flow in the detector temperature adjustment mechanism, the temperature of the substrate holder, and the temperature of the detector.

5.  The inspection system of Claim 4, wherein the controller controls the holder temperature adjustment mechanism and the detector temperature adjustment mechanism so that an estimated temperature of the substrate approaches a predetermined inspection temperature.

6. The inspection system of Claim 4 or 5, wherein the controller controls the holder temperature adjustment mechanism and the detector temperature adjustment mechanism so that a difference between the estimated temperature of the substrate and the temperature of the detector falls within a predetermined threshold.

7. The inspection system of Claim 1, wherein the controller calculates a target holder temperature and a target detector temperature, based on a heat flow by the inspection power, which is output when the inspection power is supplied, a heat flow in the holder temperature adjustment mechanism, a heat flow in the detector temperature adjustment mechanism, and the temperature of the substrate holder, and the temperature of the detector,

wherein the holder temperature adjustment mechanism controls the temperature of the substrate holder to be the target holder temperature, and
wherein the detector temperature adjustment mechanism controls the temperature of the detector to be the target detector temperature.

8. The inspection system of Claim 1, wherein the detector includes a detector configured to detect a plurality of electrical characteristics.

9. The inspection system of Claim 1, wherein the substrate includes the electrode and an electronic device connected to the electrode, and
wherein the detector detects electrical characteristics of the electronic device to which the inspection power is supplied.

10. A temperature control method for an inspection system that inspects a substrate while performing temperature control,

wherein the inspection system comprises a substrate holder configured to hold the substrate, a detector configured to supply inspection power to an electrode of the substrate, a holder temperature adjustment mechanism configured to detect a temperature of the substrate holder and adjust the temperature of the substrate holder, and a detector temperature adjustment mechanism configured to detect a temperature of the detector and adjust the temperature of the detector, and
wherein the temperature control method comprises performing inspection of the substrate while adjusting temperature control performed by the holder temperature adjustment mechanism and the detector temperature adjustment mechanism.

11. The temperature control method of Claim 10, further comprising performing the inspection of the substrate while adjusting a temperature of the substrate, by acquiring and collectively analyzing a heat flow by the inspection power, which is output when the inspection power is supplied, a heat flow in the holder temperature adjustment mechanism, and a heat flow in the detector temperature adjustment mechanism.

12. The temperature control method of Claim 10, further comprising performing the inspection of the substrate while adjusting a temperature difference between the substrate and the detector, by acquiring and collectively analyzing a heat flow by the inspection power, which is output when the inspection power is supplied, a heat flow in the holder temperature adjustment mechanism, and a heat flow in the detector temperature adjustment mechanism.

13. The temperature control method of Claim 10, further comprising estimating a temperature of the substrate, based on a heat flow by the inspection power, which is output when the inspection power is supplied, a heat flow in the holder temperature adjustment mechanism, a heat flow in the detector temperature adjustment mechanism, the temperature of the substrate holder, and the temperature of the detector.

14. The temperature control method of Claim 13, further comprising controlling the holder temperature adjustment mechanism and the detector temperature adjustment mechanism so that the estimated temperature of the substrate approaches a predetermined inspection temperature.

15. The temperature control method of Claim 13 or 14, further comprising controlling the holder temperature adjustment mechanism and the detector temperature adjustment mechanism so that a difference between the estimated temperature of the substrate and the temperature of the detector falls within a predetermined threshold.

16. The temperature control method of Claim 13, further comprising:

calculating a target holder temperature and a target detector temperature, based on the heat flow by the inspection power, which is output when the inspection power is supplied, the heat flow in the holder temperature adjustment mechanism, the heat flow in the detector temperature adjustment mechanism, and the temperature of the substrate holder, and the temperature of the detector;
controlling the holder temperature adjustment mechanism to control the temperature of the substrate holder to be the target holder temperature, and
controlling the detector temperature adjustment mechanism to control the temperature of the detector to be the target detector temperature.

# FIG. 1

# FIG. 2

# FIG. 3

# FIG. 4

FIG. 5

EP 4 651 187 A1

# FIG. 6

FIG.7

## INTERNATIONAL SEARCH REPORT

| International application No. |
|---|
| **PCT/JP2023/047262** |

**A. CLASSIFICATION OF SUBJECT MATTER**

*H01L 21/66*(2006.01)i
FI:  H01L21/66 B

According to International Patent Classification (IPC) or to both national classification and IPC

**B. FIELDS SEARCHED**

Minimum documentation searched (classification system followed by classification symbols)

H01L21/66

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2008-64490 A (YAMAHA CORPORATION) 21 March 2008 (2008-03-21) | 1, 8-10 |
| A | paragraphs [0007], [0019]-[0047], fig. 1-9 | 2-7, 11-16 |
| X | JP 6-349909 A (HITACHI, LTD.) 22 December 1994 (1994-12-22) | 1, 8-10 |
| A | paragraphs [0007], [0010]-[0019], fig. 1-3 | 2-7, 11-16 |
| X | JP 2010-186851 A (OKI SEMICONDUCTOR CO., LTD.) 26 August 2010 (2010-08-26) | 1, 8-10 |
| A | paragraphs [0009], [0016]-[0033], fig. 1-5 | 2-7, 11-16 |
| X | JP 2010-38651 A (FUJITSU MICROELECTRONICS LTD.) 18 February 2010 (2010-02-18) | 1, 8-10 |
| A | paragraphs [0009], [0015]-[0061], fig. 1-4 | 2-7, 11-16 |

[✓] Further documents are listed in the continuation of Box C.    [✓] See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **14 February 2024** | **05 March 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

International application No.

**PCT/JP2023/047262**

| C. | DOCUMENTS CONSIDERED TO BE RELEVANT | |
|---|---|---|
| Category* | Citation of document, with indication, where appropriate, of the relevant passages | Relevant to claim No. |
| A | WO 2021/014724 A1 (TOKYO ELECTRON LIMITED) 28 January 2021 (2021-01-28) paragraphs [0006], [0011]-[0092], fig. 1-17 | 1-16 |

Form PCT/ISA/210 (second sheet) (July 2022)

INTERNATIONAL SEARCH REPORT
Information on patent family members

International application No.

**PCT/JP2023/047262**

| Patent document cited in search report | | | Publication date (day/month/year) | Patent family member(s) | Publication date (day/month/year) |
|---|---|---|---|---|---|
| JP | 2008-64490 | A | 21 March 2008 | (Family: none) | |
| JP | 6-349909 | A | 22 December 1994 | (Family: none) | |
| JP | 2010-186851 | A | 26 August 2010 | US 2010/0201391 A1 paragraphs [0011], [0026]-[0044], fig. 1-5 | |
| JP | 2010-38651 | A | 18 February 2010 | (Family: none) | |
| WO | 2021/014724 | A1 | 28 January 2021 | US 2022/0262661 A1 paragraphs [0007], [0028]-[0143], fig. 1-17 CN 114096933 A KR 10-2022-0034173 A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019122107 A

- JP 2023004069 A